# EUROPÄISCHE PATENTSCHRIFT

(11) **EP 1 126 528 B1**
(45) Veröffentlichungstag und Bekanntmachung des Hinweises auf die Patenterteilung: **23.11.2011**
(21) Anmeldenummer: 01102930.3
(22) Anmeldetag: 08.02.2001
(51) Int. Cl.: H01L 31/048

(54) **Photovoltaik-Element**
Photovoltaic element
Dispositif photovoltaïque

(30) Priorität: 17.02.2000 DE 20002827 U
(43) Veröffentlichungstag der Anmeldung: 22.08.2001
(73) Patentinhaber: Evonik Röhm GmbH, 64293 Darmstadt (DE)
(72) Erfinder: Benz, Volker, Dr., 64739 Höchst (DE); Blumenschein, Michael, 64625 Darmstadt (DE); Krall, Markus, 63939 Wörth (DE)

(56) Entgegenhaltungen:
- DE-A1- 3 801 989
- DE-A1- 19 814 653
- JP-A- 56 058 277
- US-A- 5 217 540

## Beschreibung

Die Erfindung betrifft ein Photovoltaikelement, bei dem mehrere Photovoltaik-Zellen zwischen zwei Platten aus Kunststoff eingeschlossen sind.

### Stand der Technik

Photovoltaik-Elemente mit zwischen transparenten Scheiben in Kunststoff eingebetteten Photovoltaik-Zellen sind allgemein bekannt. Derartige Elemente dienen z. B. zur Überdachung und Beleuchtung von Bushaltestellen und dergleichen.

DE-A 4 443 317 beschreibt ein Photovoltaikelement bei dem mehrere Photovoltaik-Zellen in ein elastisches Kunststoffmaterial zwischen zwei Polymethylmethacrylat-Platten einbettet sind. Auf diese Weise werden die Photovoltaik-Zellen gegenüber dem Eindringen von Wasser und gegenüber mechanischen Einflüssen, wie z. B. Stößen, geschützt.

DE-A 3 801 989 beschreibt ein Isolierglas-Fassadenelement, bei dem Photovoltaik-Solargenerator im Luftraum zwischen beiden Glasscheiben mittels eines elastischen Kunststoffs an einer der Scheiben angebracht sind. Anschließend wird der Solargenerator mit einem Schmelzkleber eingegossen oder mit einer Folie eingehüllt.

Klebmittel für Methylmethacrylat-Kunststoffe sind bekannt. Das Verkleben Teilen von Polymethylmethacrylat mittels Nitroethan oder Nitromethan ist bekannt aus DE-OS 2 737 270. Polymersationsklebstoffe auf Basis von Polymethylmethacrylat bzw. Methylmethacrylat, die mittels UV- oder Tageslicht ausgehärtet werden können, sind z. B. in EP-A 436 205 oder in EP-A 548 748 beschrieben. Die Verwendung von niederen Alkylformiaten in flüchtigen Klebmitteln oder Kleblacken auf Basis von Polymethylmethacrylaten sind aus EP-A 663 419 bekannt. Eine vorteilhafte Verklebungstechnik für Polymethylmethacrylat-Teile mittels Lösemittelklebstoffen in Kombination mit dickflüssigen Polymerisationsklebern ist in EP-A 675 184 beschrieben.

### Aufgabe und Lösung

Photovoltaik-Elemente wie in DE-A 3 801 989 oder in DE-A 4 443 317 beschrieben, bieten den Photovoltaik-Zellen einen guten Schutz, indem diese zwischen den Platten mittels eines Einbettungsmittels fixiert sind.

Diese Fixierungsmethode ist jedoch aufwendig. Darüberhinaus besteht insbesondere bei längerer Einwirkungszeit, die Gefahr, daß das Einbettmedium chemisch mit den eingebetteten Zellen wechselwirkt, was die Zellen, , zerstören kann. Weiterhin werden Stoßbelastungen von den umgebenden Platten über das Einbettmedium an die Photovoltaik-Zellen übertragen, was zu Beschädigungen führen kann. Ein weiteres Problem stellt die Kondensation von Wasser in den Hohlräumen dar, die zu einem Beschlagen der Scheiben und so zu einer Verminderung der Photovoltaikleistung und sogar zu einer Zerstörung der Zellen führen kann.

Es sollte daher ein verbessertes Photovoltaikelement bereitgestellt werden, das einfach herstellbar ist und die Zellen gut gegen chemische oder mechanische Einflüsse schützt.

Die Aufgabe wurde gelöst durch ein Photovoltaikelement gemäß Anspruch 1.

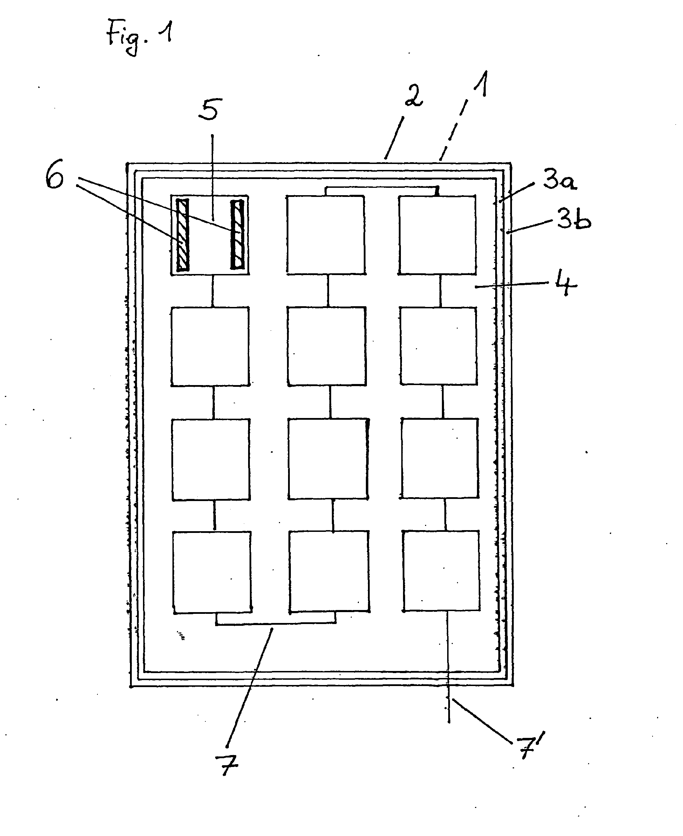

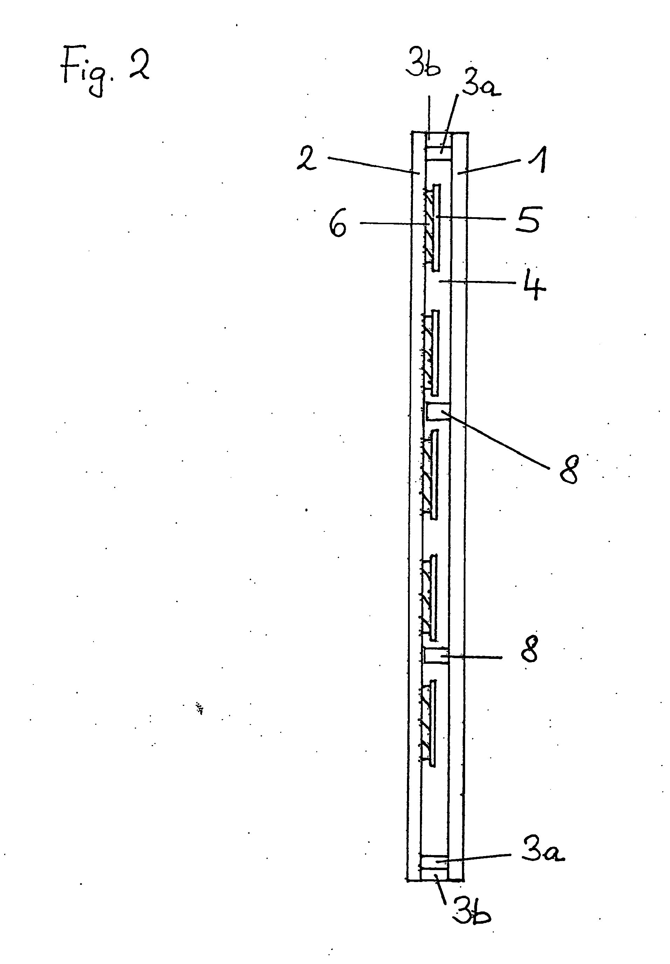

Die **Fig. 1/2** und **2/2** sind rein schematische und nicht maßstabsgerechte Darstellungen. Sie dienen lediglich der besseren Verdeutlichung der Erfindung und sollen nicht in irgendeinerweise einschränkend zu verstehen sein.
**Fig. 1/2** zeigt ein erfindungsgemäßes Photovoltaikelement mit insgesamt 12 Photovoltaikzellen schematisch von vorne, wobei die Klebeverbindungen (6) der Einfachheit halber nur beim Photovoltaikelement oben links eingezeichnet sind. Die Sperrschicht (3a) und die Klebeschicht (3b) sind durch die aufliegende transparente Platte (2) sichtbar. Die Platte (1) liegt dahinter. Die Leiterbahnen (7) und (7') sind rein schematisch eingezeichnet.
**Fig. 2/2** zeigt ein erfindungsgemäßes Photovoltaikelement von der Seite bzw. im Querschnitt. Aus dieser Perspektive sind 5 übereinanderliegende Photovoltaikelemente (5) mit entsprechende Klebeverbindungen (6) sichtbar. Leiterbahnen (7) und (7') sind nicht eingezeichnet. Die Abstandhalterblöckchen (8) sind nur mit der Platte (1) fest verbunden.

### Bezugszeichenliste:

(1) Platte aus Kunststoff (hintere Platte)
(2) Platte aus Kunststoff (vordere Platte)
(3) Umlaufende Dichtung bestehend aus einer Sperrschicht (3a) und einer Klebeschicht (3b)
(4) Hohlraum
(5) Photovoltaikzellen
(6) Klebeverbindung zur Befestigung der Photovoltaikzellen
(7) Leiterbahnen
(7') Leitung zur Abführung des Stroms aus den Photovoltaikzellen
(8) Abstandhalterblöckchen

### Ausführung der Erfindung

### Das Photovoltaikelement besteht aus

zwei ebenen oder gewölbten Platten (1) und (2), die durch eine umlaufende Dichtung (3) in einem Abstand im Bereich von 2 bis 20, bevorzugt 4 bis 10 mm verbunden sind und so einen Hohlraum (4) bilden.

Es ist erfindungswesentlich, daß die Platten (1) und (2) aus einem wasserdampfdurchlässigen Kunststoff bestehen. Dies bietet den Vorteil, daß sich auch nach längerer Zeit kein bzw. kaum Kondenswasser im Hohlraum (4) des Photovoltaikelements bildet bzw. vorhandenes Kondenswasser wieder entweichen kann.

Unter wasserdampfdurchlässigen Kunststoff werden dabei Kunststoff mit einer Wasseraufnahmefähigkeit von mindestens 0,5 % verstanden. Solche Kunststoff sind z. B. Polymethylmethacrylat, Polycarbonat, Polyester, Polystyrol oder einem Polyvinylchlorid. Bevorzugt ist Polymethylmethacrylat-Kunststoff aus gegossenem oder extrudiertem Material wegen seiner relativ hohen Wasseraufnahmefähigkeit von ca. 2 % bei gleichzeitig hoher Transparenz und guten mechanischen Eigenschaften. Polycarbonat ist ebenfalls bevorzugt, da es den Vorteil einer vergleichsweise hohen Wasserdampfdurchlässigkeit bietet.

Die Platten (1) und (2) können aus verschiedenen Kunststoffen bestehen, bevorzugt wird jedoch das gleiche Kunststoffmaterial eingesetzt.

Die Platte (1) kann als hintere, dem Licht abgewandte Platte bezeichnet werden, während die Platte (2) die Aufgabe hat, das Licht fürdie Photovoltaikzellen durchzulassen.

Die Platte (2) soll deshalb ausreichend transparent sein, was bei einem Lichttransmissionsgrad nach DIN 67 507 von mindestens 60 %, bevorzugt mindestens 70 %, besonders bevorzugt mindestens 85 % der Fall ist.

Günstige Plattendicken für die Platte (2) liegen im Bereich von 4 bis 20, bevorzugt 4 bis 12 mm.

Sofern nur eine Seite des Photovoltaikelements lichtdurchlässig gestaltet werden soll, kann die Platte (1) aus weniger transparentem, z. B. transluzentem oder eingefärbten Kunststoffmaterial bestehen. Die Platte (1) kann auch aus einem aufgrund seiner Dicke oder seiner Geometrie weniger transparentem Kunststoffkörper bestehen, z. B. einer Stegmehrfachplatte.

Als Platte (1) kann z. B. eine Stegplatte aus Polymethylmethacrylat oder aus Polycarbonat verwendet werden. Das Photovoltaikelement kann dann wärmedämmendes Bedachungs- oder Fassadenelement verwendet werden.

Ebenso kann als Platte (1) eine Lärmschutzwand aus Polymethylmethacrylat sein, auf die ganz oder teilweise eine Platte (2) aufgebracht wird.

Die Verwendung von Polymethylmethacrylat für die Platten (1) und (2) hat insbesondere den Vorteil der guten Verformbarkeit, so daß sich neben ebenen Photovoltaikelementen auch gebogene Formen, wie z.. B. Tonnengewölbe für Überdachungselemente leicht realisieren lassen. Die Verformung kann grundsätzlich auch nachträglich durch Biegen von ebenen Elementen, bevorzugt im thermoplastischen Zustand (Thermoverformung), erfolgen und ist prinzipiell auch bei den anderen genannten thermoplastischen Kunststoffen möglich.

### Befestigung der Photovolatik-Zellen

In Hohlraum (4) sind mehrere Photovoltaik-Zellen (5) eingeschlossen, die jeweils nur an der Platte (2) mittels einer Klebeverbindung (6) befestigt sind, die höchstens 30 %, bevorzugt höchstens 20, besonders bevorzugt höchstens 10 % der Fläche der einzelnen Photovoltaik-Zellen abdeckt.

Die einseitige Klebeverbindung dient der Fixierung der Zellen wobei Stöße auf die Platten nur über die Klebeverbindungen und nicht über die gesamte Fläche weitergegeben werden, was die Gefahr einer Beschädigung durch Stoß vermindert. Um die Stoßgefahr weiter zu reduzieren wird bevorzugt eine elastische Klebeverbindung, Z. B. ein doppelseitiges Klebeband aus einem weichen Acrylatkleber verwendet. Eine Zelle von 10 mal 10 cm Fläche kann z. B. mit einem oder zwei Streifen der Fläche 0,5 mal 5 cm an einer der beiden Platten fixiert werden.

Geeignet sind insbesondere Acrylatklebebänder auf Basis von elastischen Acrylaten mit relativ hohen Anteilen, z. B. 10 bis 100 Gew.-%, von Ethylacrylat oder Butylacrylat, gegebenenfalls mit Weichmacheranteilen.

Die Befestigung mit der einseitigen Klebeverbindung (6) bietet weiterhin den Vorteil, daß, sofern die Klebeverbindung sie an der lichtabsorbierenden Seite der Zellen aufgebracht werden soll, nur wenig der Fläche abdeckt wird und so die Lichtaufnahme der Zellen nur geringfügig vermindert wird. Dies kann z. B. der Fall sein, wenn die Zellen in einem Überdachungselement angebracht werden, daß von der Unterseite der Betrachtung zugänglich ist. In diesem Fall bietet es sich an die Klebestreifen, an der dem Betrachter abgekehrten Dachseite anzubringen, was optisch vorteilhafter erscheint, insbesondere da praktisch alle Klebeverbindung im Lauf der Zeit eine gewisse Vergilbung zeigen. In diesem Fall wird bevorzugt eine lichtdurchlässige Klebeverbindung gewählt, um die Verminderung der Lichtaufnahme der Zellen durch den Klebestreifen möglichst gering zu halten..

### Photovoltaik-Zellen

Übliche Photovoltaik-Zellen (5) haben eine meist quadratische Fläche im Bereich von ca. 10 bis 15 cm Kantenlänge bei einer Dicke von 0,5 bis 2 mm.

Die mögliche Leistung liegt im Bereich von 1,3 bis 2 Watt.

In der Regel werden die Zellen in quadratischen oder rechteckigen Feldern von z. B. 10 mal 6 Zellen oder ähnlich nebeneinander mit Zwischenabständen von 1 bis 3 cm angeordnet. Der Flächenanteil der Photovoltaik-Zellen an der Gesamtfläche der Photovoltaik-Elemente liegt im Bereich von 20 bis 80, bevorzugt zwischen 40 und 60 %.

Die einzelnen Zellen werden dabei mittels Leiterbahnen (7), auch als "Strings" bezeichnet, zu elektrischen Einheiten zusammengeschaltet. Zur Abführung der elektrischen Leistung bzw. des erzeugten Stroms muß zumindest eine Leitung (7') aus dem Photovoltaikelement nach außen geführt werden (Bei Reihenschaltung sind jeweils eine Leitung bzw. Kabel zweckmäßigerweise vom ersten und eines vom letzten Element nach außen zu führen).

### Abmessungen

Die Platten (1) und (2), die die Photovoltaik-Zellen einschließen, weisen einen Abstand von 2 bis 20, bevorzugt 2 bis 4 mm auf, der z. B. durch Abstandhalter gewährleistet werden kann. Wichtig ist, daß die Photovoltaik-Zellen zwischen den Platten durch eine umlaufende Dichtung eingeschlossen sind. Diese verhindert ein Eindringen von Feuchtigkeit in das Element.

### Die umlaufende Dichtung

Die Photovoltaikelemente werden mittels einer umlaufenden Dichtung (3) umgeben, wobei die Leitung zur Abführung des Stroms (7) günstigerweise hindurch nach außen geführt wird. Die umlaufende Dichtung (3) hat die Aufgabe, die Elemente wasserdicht einzuschließen. Die umlaufende Dichtung kann aus mehreren Schichten, insbesondere zwei Schichten bestehen, wobei zunächst ein innere Schicht als Sperrschicht (3a) zwischen den Photovoltaikzellen dient, damit als äußere Schicht oder Klebeschicht (3b) ein Polymerisationskleber verwendet werden kann, ohne daß Lösemittel- bzw. Monomerdämpfe im Hohlraum (4) eingeschlossen werden, die später zur Spannungsrißkorrosion führen können.

Die umlaufende Dichtung kann z. B. aus Polymethylmethacrylat, Polyurethan, EPDM oder Polysilikonkautschuk bestehen.

### Herstellung der Photovoltaikelemente

Auf der Platte (2) werden die Photovoltaikelemente mittels oben genannter Klebeverbindung fixiert.

Bei ebenen Photovoltaikelementen kann man die umlaufende Dichtung z. B. einrichten, indem man vier rechteckige Stäbe (Querschnitt z. B. 10 x 10 mm, Länge je nach Bedarf) aus Polymethylmethacrylat zu einem rechteckigen Rahmen um die Photovoltaikelemente herum zusammenfügt und mittels eines geeigneten Lösemittels, z. B. Methylenchlorid mit der Platte (2) und untereinander durch Anlösen der Berührungsflächen miteinander verbindet. Es ist wichtig, daß man das Lösemittel gründlich abdampfen läßt, z. B. für die Dauer von 1 bis 4 Stunden, bevor man die Platte (1) auf den umlaufenden Rahmen auflegt.

Ist der einzuschließende Hohlraum groß, kann es zweckmäßig sein zusätzlich zur umlaufenden Dichtung Abstandhalter (8) gleicher Höhe in Zwischenabständen anzubringen, die aber nur mit der Platte (1) oder mit der Platte (2) verklebt werden sollen, damit im Element insgesamt Toleranzen gegenüber Verspannungen erhalten bleiben. Es können z. B. kleine Blöckchen aus Polymethylmethacrylat verwendet werden,.

Man kann nun die Platten (1) und (2) außerhalb der Sperrschicht mit einer Klebeschicht, bevorzugt einem dickflüssigen Polymethylmethacrylat-Polymerisationskleber durch eine umlaufende Raupe fest verschließen. Nach der Auspolymerisation der Klebeschicht ist das Photovoltaikelement mechanisch stabil. Die Sperrschicht ist dabei nur mit der Platte (2) fest verbunden, verhindert aber, da sie dichtend auf der Platte (1) aufliegt, in ausreichender Weise, daß Dämpfe von Methylmethacrylat aus dem Polymerisationskleber während oder nach der Polymerisation der Klebeschicht in den Hohlraum gelangen.

Zur Verhinderung von Materialspannungen kann man das Photovoltaikelement noch einer Temperung, z. B. 2 bis 5 Stunden bei 70 °C, unterziehen.

Man kann die Dichtwirkung noch erhöhen, indem man die Oberseite des Rahmens aus Polymethylmethacrylat vor dem Auflegen der Platte (1) mit wenig Lösemittel versieht, so daß sich das Polymethylmethacrylat leicht anlöst, das wenige Lösungsmittel aber fast unmittelbar verdampft ist uns dann die Platte (1) nach kurzer Wartezeit von z. B. 1 bis 5 Minuten auflegt. Dadurch wird erreicht, daß die Platte (1) zumindest leicht am Rahmen klebt, wodurch die Dichtwirkung bzw. Sperrwirkung verbessert ist.

Alternativ zum oben beschriebenen Rahmen aus Polymethylmethacrylat kann man die umlaufende Dichtung auch einem elastischen Material herstellen, wobei dann bevorzugt zusätzlich Abstandshalter, z. B. Blöckchen aus demselben Kunststoffmaterial der Platte (2) verwendet werden. Die Abstandhalter können an der Platte (2) oder auch an der Platte (1) mit einem Lösemittelkleber fixiert werden. In diesem Fall erzeugt man eine umlaufende elastische Dichtung, die etwas höher ist als die Anstandhalter, so daß nach sich nach dem Auflegen der Platte (1) auf den Abstandhaltern aufliegt und die umlaufende Dichtung andrückt, wodurch ein dichter Hohlraum gebildet wird, der die Photovoltaikelemente einschließt.

Als elastisches Material für die umlaufende Dichtung kann ein Polyurethankleber, ein Polysilikonkautschuk oder ein Lösemittelkleber mit Polymer eingesetzt werden. Letztere können z. B. Polymethylmethacrylat in Lösemittel (z. B. Dichlormethan, Nitromethan, Methylformiat, Ethylformiat, Methylenchlorid), Polycarbonat in Lösemittel (Tetrahydrofuran), Polyvinylchlorid oder Polystryrol in Lösemittel sein. Für Platten aus Polycarbonat eignen sich insbesondere Kleber auf Basis von Polyurethan. Gut geeignet für Platten aus Polymethylmethacrylat sind weiche Acrylatkleber, z. B. Polyethylacrylat gelöst in Essigsäureethylester.

Anschließend werden die Platten (1) und (2) mittels eines handelsüblichen Polymerisationsklebers fest verbunden. Geeignete Poymerisationskleber für Polymethylmethacrylat sind z. B. in der EP-A 548 740 beschrieben. In der Regel enthalten derartige Klebstoffe ca. 30 Gew.-% Polymer (Polymethylmethacrylat) gelöst in Monomer (Methylmethacrylat) sowie einen oder gegebenenfalls mehrere Polymerisationsinitiatoren.

### BEISPIEL

In einer bevorzugten Anordnung werden mehrere Photovoltaik-Zellen (5), z. B. ein Feld aus 10 mal 10 Zellen mit Zwischenabständen von ca. 1 cm, mittels transparenter Klebestreifen (6), z. B. von je zweimal 0,5 mal 5 cm aus doppelseitigem, elastischen Acrylatklebeband die über Leiterbahnen (7) verbunden sind, auf einer Polymethylmethacrylat-Platte (2) von 150 mal 150 cm Fläche und 1 cm Dicke fixiert. Das Stromabführkabel (7') des elektrischen Zellenverbunds wird seitlich abgeführt (Die Verkabelung von der ersten Zelle nach außen ist der Übersichtlichkeit halber nicht eingezeichnet). Es werden mehrere Abstandhalter-Blöckchen aus Polymethylmethacrylat (8) von 1 mal 1 cm und 1 mm Dicke mittels Anlösen der Grenzfläche zur Platte (2) mit Methylenchlorid aufgeklebt.

Um den Photovoltaik-Zellenverbund wird nun eine Sperrschicht (3a) aus einem weichen Acrylatkleber (Polyethylacrylat in Essigsäureethylester gelöst) aufgebracht.

Nach dem Abdampfen des Lösungsmittels, ca. 24 Stunden nach Auftrag der Sperrschicht (3a) wird die zweite Platte (1) aus Polymethylmethacrylat (3b) aufgelegt und die Ränder mit einem Polymethylmethacrylat-Polymerisationskleber (Klebeschicht 3b) verschlossen . Die Sperrschicht (3a) verhindert dabei, daß Monomerdämpfe aus dem Polymerisationskleber zu den Photovoltaik-Zellen (5) gelangen können.

Anschließend wurde das Element 360 Tage bei 85 % relativer Luftfeuchte und 80 °C gelagert. Dabei wurde weder eine Wasserkondensation im Inneren festgestellt noch eine Schädigung der Photovoltaikzellen oder der Verbindungsleiter beobachtet. Das Element zeigte nach dieser Zeit die volle Funktionsfähigkeit.

## Patentansprüche

1. Photovoltaikelement bestehend aus
zwei ebenen oder gewölbten Platten (1 und 2), Polycarbonat, Polyester, Polystyrol oder einem Polyvinylchlorid die durch eine umlaufende Dichtung (3) in einem Abstand im Bereich von 2 bis 20 mm verbunden sind und so einen Hohlraum (4) bilden, in dem mehrere Photovoltaik-Zellen (5) eingeschlossen sind, die jeweils nur an einer der beiden Platten (2) mittels einer Klebeverbindung (6) befestigt sind, wobei zumindest diese eine Platte (2) einen Lichttransmissionsgrad nach DIN 67507 von mindestens 60 % aufweist,
**dadurch gekennzeichnet, daß**
die beiden Platten aus einem wasserdampfdurchlässigen Kunststoff aus Polymethylmethacrylat bestehen und die Klebeverbindung, mit der die Photovoltaikzellen befestigt sind, höchstens 30 % der Fläche der einzelnen Photovoltaik-Zellen abdeckt.

2. Photovoltaikelement nach Anspruch 1, **dadurch gekennzeichnet, daß** die umlaufende Dichtung (3) aus Polymethylmethacrylat, Polyurethan, Polystyrol, Polyvinylchlorid oder Polysilikonkautschuk besteht.

3. Photovoltaikelement nach Anspruch 2, **dadurch gekennzeichnet, daß** sich die umlaufende Dichtung (3) aus einer Sperrschicht (3a) und einer Klebeschicht (3b) zusammensetzt.

4. Photovoltaikelement nach Anspruch 3, **dadurch gekennzeichnet, daß** die Sperrschicht (3a) ein aus Polymethylmethacrylat-Stücken zusammengesetzter Rahmen ist und die Klebeschicht (3b) aus einem Polymethylmethacrylat-Polymerisationskleber besteht.

5. Photovoltaikelement nach Anspruch 1, **dadurch gekennzeichnet, daß** die Platten (1) und (2) aus Polycarbonat-Kunststoff und die umlaufende Dichtung (3) aus einem Polyurethan-Kunststoff bestehen.

6. Photovoltaikelement nach Anspruch 1, **dadurch gekennzeichnet, daß** die andere Platte (1) eine Lärmschutzwandplatte ist.

7. Photovoltaikelement nach Anspruch 1, **dadurch gekennzeichnet, daß** die andere Platte (1) eine Stegplatte ist.

## Claims

1. Photovoltaic element consisting of
two planar or curved plates (1 and 2) which are connected by a circumferential seal (3) at a distance in the range of 2 to 20 mm and thus form a cavity (4), in which a plurality of photovoltaic cells (5) are enclosed, which are fixed in each case only to one of the two plates (2) by means of an adhesive-bonding connection (6) at least this one plate (2) having a light transmittance according to DIN 67507 of at least 60%,
**characterized in that**
the two plates consist of a water-vapour-permeable plastic composed of polymethyl methacrylate, polycarbonate, polyester, polystyrene or a polyvinyl chloride, and the adhesive-bonding connection by which the photovoltaic cells are fixed covers at most 30% of the area of the individual photovoltaic cells.

2. Photovoltaic element according to Claim 1, **characterized in that** the circumferential seal (3) consists of polymethyl methacrylate, polyurethane, polystyrene, polyvinyl chloride or polysilicone rubber.

3. Photovoltaic element according to Claim 2, **characterized in that** the circumferential seal (3) is composed of a barrier layer (3a) and an adhesive layer (3b).

4. Photovoltaic element according to Claim 3, **characterized in that** the barrier layer (3a) is a frame composed of polymethyl methacrylate pieces and the adhesive layer (3b) consists of a polymethyl methacrylate polymerization adhesive.

5. Photovoltaic element according to Claim 1, **characterized in that** the plates (1) and (2) consist of polycarbonate plastic and the circumferential seal (3) consists of a polyurethane plastic.

6. Photovoltaic element according to Claim 1, **characterized in that** the other plate (1) is a noise guard wall plate.

7. Photovoltaic element according to Claim 1, **characterized in that** the other plate (1) is a multiskin sheet.

## Revendications

1. Élément photovoltaïque constitué par deux plaques planes ou bombées (1 et 2) qui sont reliées par un joint périphérique (3) à une distance dans la plage allant de 2 à 20 mm, et forment ainsi une cavité (4) dans laquelle plusieurs cellules photovoltaïques (5) sont incorporées, qui sont chacune fixées uniquement à une des deux plaques (2) par un joint adhésif (6), au moins cette plaque (2) présentant un degré de transmission de la lumière selon DIN 67507 d'au moins 60 %,
**caractérisé en ce que**
les deux plaques sont constituées d'un plastique en polyméthacrylate de méthyle, polycarbonate, polyester, polystyrène ou polychlorure de vinyle, perméable à la vapeur d'eau et le joint adhésif avec lequel les cellules photovoltaïques sont fixées recouvre au plus 30 % de la surface des cellules photovoltaïques individuelles.

2. Élément photovoltaïque selon la revendication 1, **caractérisé en ce que** le joint périphérique (3) est constitué de polyméthacrylate de méthyle, de polyuréthane, de polystyrène, de polychlorure de vinyle ou d'un caoutchouc de polysilicone.

3. Élément photovoltaïque selon la revendication 2, **caractérisé en ce que** le joint périphérique (3) se compose d'une couche de jonction (3a) et d'une couche adhésive (3b).

4. Élément photovoltaïque selon la revendication 3, **caractérisé en ce que** la couche de jonction (3a) est un cadre composé de morceaux de polyméthacrylate de méthyle et la couche adhésive (3b) est constituée d'une colle à polymérisation à base de polyméthacrylate de méthyle.

5. Élément photovoltaïque selon la revendication 1, **caractérisé en ce que** les plaques (1) et (2) sont constituées d'un plastique polycarbonate et le joint périphérique (3) d'un plastique polyuréthane.

6. Élément photovoltaïque selon la revendication 1, **caractérisé en ce que** l'autre plaque (1) est un panneau mural antibruit.

7. Élément photovoltaïque selon la revendication 1, **caractérisé en ce que** l'autre plaque (1) est une plaque alvéolaire.
